Europäisches Patentamt

European Patent Office

Office européen des brevets

(19)

(11) Publication number: 0 376 863
A2

# (12) EUROPEAN PATENT APPLICATION

(21) Application number: 89420512.9

(22) Date of filing: 22.12.89

(51) Int. Cl.5. **H01L 39/24, H01L 23/48**

(30) Priority: 29.12.88 US 291921

(43) Date of publication of application:
04.07.90 Bulletin 90/27

(84) Designated Contracting States:
AT BE CH DE ES FR GB GR IT LI LU NL SE

(71) Applicant: **EASTMAN KODAK COMPANY**
**343 State Street**
**Rochester, New York 14650(US)**

(72) Inventor: **Strom, Laurie Ann c/o EASTMAN**
**KODAK COMPANY**
**Patent Department 343 State Street**
**Rochester New York 14650(US)**

(74) Representative: **Parent, Yves et al**
**Kodak-Pathé Département Brevets et**
**Licences Centre de Recherches et de**
**Technologie Zone Industrielle**
**F-71102 Chalon-sur-Saône Cédex(FR)**

(54) **A process of forming conductive films.**

(57) A process is disclosed of forming a crystalline heavy pnictide mixed alkaline earth copper oxide electrical conductor on a substrate by spray drying a solution comprised of a volatilizable solvent and a solute of metal-ligand compounds to form particles each containing the same metal-ligand compounds in the same proportions found in the solution, coating the particles on the substrate, heating the coated particles in the presence of oxygen to form an intermediate coating, and converting the intermediate coating to a crystalline heavy pnictide mixed alkaline earth copper oxide electrical conductor. A screen printing composition comprised of the particles is also disclosed as well as a circuit element comprised of a thick film of a superconductive crystalline heavy pnictide mixed alkaline earth copper oxide on an aluminum oxide or nitride substrate.

FIG. 1

# A PROCESS OF FORMING CONDUCTIVE FILMS

## Field of the Invention

The present invention relates to a process of forming conductive films.

## Background of the Invention

The term "superconductivity" is applied to the phenomenon of immeasurably low electrical resistance exhibited by materials. Until recently superconductivity had been reproducibly demonstrated only at temperatures near absolute zero. As a material capable of exhibiting superconductivity is cooled, a temperature is reached at which resistivity decreases (conductivity increases) markedly as a function of further decrease in temperature. This is referred to as the superconducting onset transition temperature or, in the context of superconductivity investigations, simply as the critical temperature ($T_c$). $T_c$ provides a conveniently identified and generally accepted reference point for marking the onset of superconductivity and providing temperature rankings of superconductivity in differing materials. The highest temperature at which superconductivity is observed in a material is designated $T_o$.

Unless otherwise indicated, the term "thick film" refers to films having thicknesses of greater than 5 $\mu$m while the term "thin film" refers to films having thicknesses which are in all instances less than 5 $\mu$m and more typically less than 1 $\mu$m.

T. Hashimoto, T. Kosaka, Y. Yoshida, K. Fueki, and H. Koinuma, "Superconductivity and Substrate Interaction of Screen-Printed Bi-Sr-Ca-Cu-O Films", Japanese Journal of Applied Physics, Vol. 27, No. 3, March, 1988, pp. L384-L386, reports successful attempts to form superconductive thick films of bismuth strontium calcium copper oxide on yttrium stabilized zirconia and strontium titanate substrates. Hashimoto et al failed to produce superconducting films on quartz and alumina substrates. The thick films were prepared by screen printing. Bismuth strontium calcium copper oxides with nominal 1112 and 2213 compositions were prepared by calcining bismuth and copper oxides with strontium and calcium carbonates for 800°C for 12 hours, followed by mixing with a mortar and pestle while adding octyl alcohol to form a paste. The paste was screen printed.

T. Nakamori, H. Abe, Y. Takahasi, T. Kanamori, and S. Shibata, "Preparation of Superconducting Bi-Ca-Sr-Cu-O Printed Thick Films Using a Coprecipitation of Oxalates", Japanese Journal of Applied Physics, Vol. 27, No. 4, April 1988, pp. L649-L651, reports successful attempts to form superconductive thick films of bismuth strontium calcium copper oxide on monocrystalline magnesia substrates. The thick films were prepared by screen printing. Calcium, strontium, and copper chlorides were coprecipitated with oxalates. Bismuth oxalate was separately precipitated from acetone. These two precipitates were separately washed, filtered, and dried before being mixed as solids and heated to 300°C. Bismuth strontium calcium copper oxide with a nominal 1112 composition was prepared.

K. Hoshino, H. Takahara, and M. Fukutomi, "Preparation of Superconducting Bi-Sr-Ca-Cu-O Printed Thick Films on MgO Substrate and Ag Metal Tape", Japanese Journal of Applied Physics, Vol. 27, No. 7, July 1988, pp. L1297-L1299, reports successful attempts to form superconductive thick films of bismuth strontium calcium copper oxide on monocrystalline magnesia substrates, silver, and some metal tapes. The thick films were prepared by calcining techniques similar to those described by Hashimoto et al, cited above. The bismuth strontium calcium copper oxide exhibited a nominal 1112 composition.

As between superconducting ceramic oxide thick films and thin films, it is apparent that higher currents in the superconducting mode can be sustained by the former. In attempting to prepare thick films of heavy pnictide mixed alkaline earth copper oxide it is desirable to achieve the most uniform and intimate mixture possible of the precursors forming the mixed metal oxide to avoid the localized formation of mixed and lower conductivity phases.

Uniform, intimate mixing of precursors has been achieved in preparing thin films of bismuth mixed alkaline earth copper oxides by placing salts of the metals in solution in their desired proportions, coating the solution on a substrate, and removing the solvent. Subsequent heating results in the desired crystalline mixed metal oxide. While this approach works well to prepare thin films of well below 1 $\mu$m in thickness, thicknesses typically being measured in Angstroms, it is not a feasible approach to forming thick films. The final coating thickness is much less than that of the solution layer containing the precursors. Attempting to increase the solution layer thickness, as by increasing its viscosity, is not feasible, since the high thickness shrinkage of solution coatings on heatng produces thick films which are riddled with stress fractures and therefore form inferior electrical conductors.

Hashimoto et al, Nakamori et al, and Hoshino et al all seek to form intimate mixtures of bismuth mixed alkaline earth copper oxide precursors by phsically mixing solids (e.g., calcining mixed solids). The difficulty with this approach is that the intimate and uniform mixtures of precursors obtainable by placing the precursors in a common solvent cannot be realized, even with laborious and repeated blending attempts.

Summary of the Invention

The present invention overcomes blending problems encountered by the prior art in preparing thick films of heavy pnictide mixed alkaline earth copper oxides. The invention facilitates the intimate and uniform distribution of these metal oxides and their precursors thereby allowing thick films of highly desirable electrical conduction characteristics to be prepared.

Additionally, the present invention makes available for the first time particles containing heavy pnictide mixed alkaline earth copper oxide precursors in which each particle contains exactly the same ratio of these metals.

In one aspect, this invention is directed to a process of forming an electrical conductor on a lower conductivity substrate comprising (i) forming a coating of a precursor of a crystalline heavy pnictide alkaline earth copper oxide electrical conductor on the substrate and (ii) converting the precursor to a crystalline heavy pnictide alkaline earth copper oxide electrical conductor.

The process is characterized by the steps of (a) spraying a solution comprised of a volatilizable solvent and a solute of metal-ligand compounds to form discrete liquid particles, the ligand moieties of the compounds being chosen to thermally decompose and the metal moieties of the compounds being chosen to provide the metals required for the precursor, (b) evaporating at least a portion of the volatilizable solvent from the liquid particles to form solid particles, (c) coating the solid particles on the substrate, (d) heating the coated particles in the presence of oxygen to form the precursor as an intermediate coating on the substrate, and (e) converting the intermediate coating to a crystalline heavy pnictide mixed alkaline earth copper oxide electrical conductor.

Brief Description of the Drawings

These and other advantages of the invention can be better appreciated by reference to the following detailed description of preferred embodiments considered in conjunction with the drawings, in which

Figure 1 is schematic diagram showing process steps and articles produced thereby and

Figure 2 is a cross-sectional view of an electric circuit component.

Description of Preferred Embodiments

The present invention is generally applicable to all known conductive heavy pnictide mixed alkaline earth copper oxide compositions. The term "PAC" is employed herein as an acronym for heavy pnictide mixed alkaline earth copper oxides generally. The acronym "RAC" is employed to indicate rare earth alkaline earth copper oxide compositions, referred to from time to time to compare and contrast the properties of the PAC layers. The designation of an element Group by an arabic rather than a Roman numeral is based on the Periodic Table of elements as adopted by the American Chemical Society and under consideration for adoption by IUPAC.

Except as otherwise noted, all steps in the preparation of electrically conductive articles according to this invention are understood to be practicable in air at atmospheric pressure, unless otherwise indicated. It is, of course, recognized that increasing the proportion of ambient oxygen present and operation at elevated pressures, used separately or together, is generally compatible with the practice of this invention and can be employed, although not required.

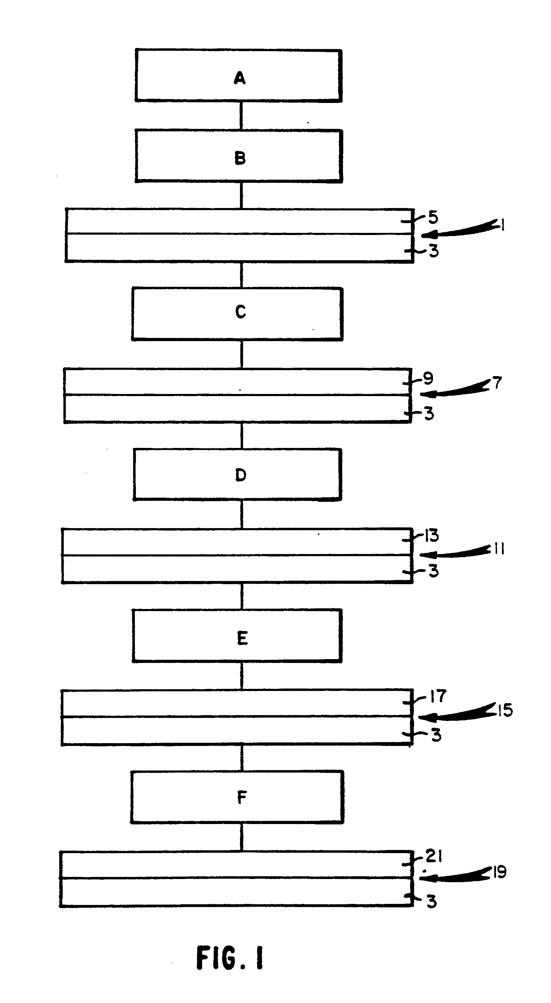

The present invention can be appreciated by the schematic diagram shown in Figure 1. In Step A a composition containing particles of metal-ligand compounds is obtained. Each particle contains heavy pnictide, alkaline earth, and copper atoms in the same ratio desired in the final PAC containing conductive layer. Further, the atoms are intimately intermixed so that the composition of each particle is preferably essentially uniform. Associated with the metal atoms and completing the compounds are volatilizable ligands, which can be all alike or chosen from among different ligands.

The particles can be of any size convenient for coating. The particles can exhibit a mean diameter up to the thickness of the coating to be formed, but more uniform films are realized when the mean particle diameters are relatively small in relation to the thickness of the film to be formed. The particles are preferably less than about 2 $\mu$m in mean diameter, optimally less than 1 $\mu$m in mean diameter. The minimum mean diameter of the particles is limited only by synthetic convenience.

A preferred technique of this invention for producing metal-ligand compound particles is to dissolve the heavy pnictide, alkaline earth, and copper metal-ligand compounds in a mutual solvent and then to spray the solution through an atomizing nozzle into a gaseous atmosphere. The solvent is chosen to be evaporative in the gaseous atmosphere. Thus, the individual particles are dispersed in the gaseous atmosphere as liquid particles and eventually come to rest at a collection site as either entirely solid particles or particles in which the proportion of solvent has been sufficiently reduced that each of the metal-ligand compounds present has precipitated to a solid form. In the latter instance the particles by reason of the residual solvent, now no longer acting as a solvent, but only as a continuous dispersing phase, form a paste. The paste constitutes a highly convenient coating vehicle. When the particles are collected in a friable form with all or substantially all of the initially present solvent removed, it is recognized that a paste can still be formed, if desired, by adding to the particles a small amount of a liquid to promote particle cohesion-i.e., to constitute a paste.

Only a very small amount of liquid is required to promote particle cohesion and thereby form a paste. Typically the liquid constitutes less than 20 percent of the total composition weight and preferably less 15 percent of the total compositon weight. While optimum paste consistencies can vary depending upon the selection of processes for coating the paste, it is generally contemplated that the paste viscosity will be in the range of from $5 \times 10^4$ to $3 \times 10^6$ centipoise, preferably from $1 \times 10^5$ to $2.5 \times 10^6$ centipoise.

While atomization and drying can be undertaken in air at room temperatures, it is recognized that any gaseous medium which does not detrimentally react with the metal-ligand compounds can be employed. Further, the temperature of the liquid forming the particles or, preferably, the gaseous medium can be increased to accelerate the solvent evaporation rate, provided only that such elevated temperatures in all instance be maintained below the thermal decomposition temperatures of the metal-ligand compounds.

The advantage of solidifying the metal-ligand compounds while they are trapped within discrete particles is that bulk separations of the heavy pnictide, alkaline earth, and copper are prevented. The particle preparation approach offers distinct advantages over simply evaporating bulk solutions to dryness in that each particle produced by the process of this invention contains the desired ratio of heavy pnictide, alkaline earth, and copper elements. This produces a solid particle coating composition of microscale uniformity.

In Step B of the preparation process, onto a substrate are coated the metal-ligand compound particles, preferably combined with a carrier liquid to form a coatable paste or slurry. The resulting coated article 1 as schematically shown consists of substrate 3 and a layer 5 formed by PAC precursors (metal-ligand compounds) and film forming solvent. Although the layer 5 is shown coextensive with the substrate 3, it is appreciated that the particles are well suited, particularly when coated in the form of a paste or slurry, to being laid down in any desired pattern on the substrate. The paste can, for example, be deposited by any of a variety of conventional image defining coating techniques, such as screen or gravure printing. Since thick conductive films are most commonly formed in the art by screen printing, the present invention is highly compatible with conventional printed circuit preparation processes.

In Step C article 1 is heated to a temperature sufficient to volatilize at least a portion of the ligands and the carrier liquid. The element 7 resulting consists of substrate 3 and amorphous PAC layer 9. In its amorphous form the PAC coating exhibits relatively low levels of electrical conductivity. It should be understood that the term "amorphous" layer as used herein does not exclude a portion of the components making up the layer from exhibiting some crystallinity as observed by X-ray diffraction analysis and represents a mixture of oxides of the various metals comprising the layer. Further, in some instances one or more metals, particularly the alkaline earths, may be present as a carbonate. However, for purposes of this description such carbonates shall be broadly included in the term "oxide" when referring to the mixture of oxides or amorphous PAC layer. It is known to those skilled in the art that such carbonates are decomposable to the metal oxide upon further heating.

Once the amorphous PAC layer 9 has been formed on the substrate 3 subsequent conversion of this intermediate layer to a final crystalline conductive PAC layer can proceed by any convenient conventional procedure. For example, the crystallization procedures for thick films employed by Hashimoto et al, Nakamori et al, and Hoshino et al, cited above, can, if desired, be employed. One of the recognized fabriction advantages of forming crystalline conductive PAC layers as opposed to crystalline conductive RAC layers is that the former exhibit superconductivity independent of whether an oxidizing or non-oxidizing

4

atmosphere is employed during their manufacture and independent of whether they are cooled slowly at controlled rates or quenched.

The disclosure which follows is directed to a preferred approach to converting an amorphous PAC thick film to a crystalline conductive PAC thick film. In general, this conversion of the thick film to its crystalline form is achieved by heating in the temperature range of from 750 to 1000°C. The temperature range of 780 to 850°C is preferred when a non-oxidizing atmosphere is employed for converting the amorphous PAC thick film to its crystalline conductive form. A non-oxidizing atmosphere can be provided by any convenient relatively inert gas, such as nitrogen or a Group 18 gas, typically argon. Alternatively, a non-oxidizing atmosphere can be created simply by firing the amorphous PAC thick film at a reduced ambient pressure, thereby reducing oxygen availability. On the other hand, when crystallization of the PAC layer is undertaken in air or an oxygen enriched atmosphere, it is preferred to employ temperatures in the range of from about 850 to 950°C.

While a single heating step in either a non-oxidizing or oxygen containing atmosphere can be employed to convert the amorphous PAC thick film to a crystalline conductive PAC thick film, advantages have been observed to flow from employing a firing step in combination with a pre-firing step, a post-firing step, or both. Generally optimum results in terms of realizing superconductivity at the highest possible temperatures are realized when the pre-firing, firing, and post-firing steps are all employed in combination.

Referring to Fig. 1, Step D represents a pre-firing step, Step E represents the firing step, and Step F represents a post-firing step. Although crystals are observed in each of PAC thick films 13, 17, and 21, progressively more desirable crystallizations in terms of crystal phases formed and their orientation are observed with the completion of each firing.

In the presence of oxygen (e.g., in an air or oxygen atmosphere) it is preferred to heat the PAC layer in the temperature range of from 890 to 950°C during firing step E. In a non-oxidizing atmosphere similar results are achieved in the temperature range of from about 830 to 850°C. It is believed that in these temperature ranges at least some melting of the PAC composition occurs. This improves adhesion to the substrate and also facilitates crystal formation and orientation, either during this step or during subsequent cooling. The PAC layer should be fired within the preferred temperature ranges for at least 5 minutes, preferably at least 10 minutes. Generally the benefit of firing is realized quickly, so that extended firing times are not required. Useful crystalline conductive PAC layers can be achieved when firing times are extended to 100 hours or more, but in practice rarely are firing times in excess of 2 hours employed.

In the pre-firing Step D the PAC layer is heated to temperatures below the firing temperatures of Step E. Pre-firing temperatures are preferably in the range of from 800 to 885°C in oxygen containing atmospheres and from 780 to 830°C in non-oxidizing atmospheres. Post-firing temperatures for step F are preferably in the range of from 870 to 890°C in oxygen containing atmospheres and from 780 to 830°C in non-oxidizing atmospheres. Within these temperature ranges convenient pre-firing and post-firing times are generally similar to those suggested above for firing. However, for both pre-firing and post-firing it is possible to reduce firing temperatures somewhat below the preferred ranges and to compensate by extending the pre-firing or post-firing times.

When the crystallization of the PAC layer is undertaken in a non-oxidizing atmosphere, somewhat less than an optimum concentration of oxygen may be present in the layer. It has been observed that low level heating of such crystalline conductive PAC layers in an oxidizing atmosphere, preferably oxygen, even at comparatively low temperatures-e.g., down to about 480°C can significantly enhance conductivity-e.g., increase $T_o$.

According to accepted percolation theory, for a layer consisting of conducting spheres located in a surrounding nonconducting medium the spheres must account for at least 45 percent by volume of the layer for satisfactory electrical conductivity to be realized. If conducting particles of other geometric forms, particularly elongated forms, are substituted for the spheres, the conducting particles can account for less of the layer volume while still realizing satisfactory layer electrical conductivity. Similarly, electrical conductivity can be realized with a lesser proportion of conducting particles when the surrounding medium is also conductive. In the PAC layers the geometrical form of the conductive crystals is such that electrical conductivity is realized when these crystals form substantially less than 45 percent by volume of the layer. Satisfactory electrical conductivity is observed when the conductive crystalline phase forms only 30 percent or less by volume of the layer. However, it is generally preferred that the conductive crystalline phase form at least 70 percent, optimally at least 90 percent, by volume of the total PAC layer.

The final electrically conductive article 19 is comprised of a crystalline, electrically conductive PAC layer 21 on substrate 3. Depending upon specific choices of materials and preparation techniques, the article 19 can exhibit a high superconducting onset transition temperature.

The term "high superconducting transition onset temperature" is herein defined as a $T_c$ of greater than 30°C.

The process described for preparing electrically conductive articles having PAC layers offers several distinct advantages. One of the most significant advantages is that the proportions of heavy pnictide, alkaline earth, and copper elements in the final PAC layer 21 exactly correspond to those present in the PAC precursor layer 5. In other words, the final proportion of rare earth, alkaline earth, and copper elements is determined merely by the desired proportions in the the metal-ligand compound particles employed as starting materials. This avoids what can be tedious and extended trial and error adjustments of proportions required by commonly employed metal oxide deposition techniques, such as sputtering and vacuum vapor deposition. Further, the present process does not require any reduction of atmospheric pressures, and thus no equipment for producing either high or low vacuum.

A particular advantage of the present process is that it readily lends itself to the formation of electrical conductor patterns on limited portions of substantially planar substrate surfaces. Thus, the present process is readily applied to the fabrication of printed and hybrid circuits. Patterning can be readily achieved by coating the layer 5 of article 1 in the desired pattern, as described above. As an adjunct or alternative to metal-ligand compound coating patterning any one of the PAC layers 9, 13, 17, or 21 of articles 7, 11, 15, or 19 can be patterned by conventional photoresist pattern definition and etching of the PAC layer.

Although the foregoing process has been described in terms of extremely simple articles in which the PAC layer is formed entirely on a insulative substrate, it is appreciated that in many practical applications only a portion of the PAC layer will be formed directly on a surface of the substrate. For example, in fabricating electrical circuit components it is common practice to first coat metal pads (conductive areas) on an insulative substrate for the purpose of facilitating external lead (pin) connections. The PAC layer or several portions of the PAC layer can be formed on the insulative substrate to provide a conduction path or paths between spaced pads or other conductive regions previously formed on the substrate. Any conductive material can be precoated on the substrate which is capable of withstanding the temperatures required to form the PAC layer. For example, gold pads are commonly used in electrical circuit component fabrication and are entirely compatible with fabricating PAC layers as required by this invention. Electrical connection to the surface of a thick film which has already been coated on the substrate and fired to produce the electrically conductive PAC phase is also possible. Metal pads (e.g., indium) can be made to adhere to the crystalline PAC surface at relative low temperatures (< 200°C). Subsequent electrical connection to the the overlying metal pad can be made using conventional bonding techniques-e.g., soldering techniques, such as with a lead tin solder. For example, copper wire can be soldered to the overlying pad to complete the desired electrical conduction path.

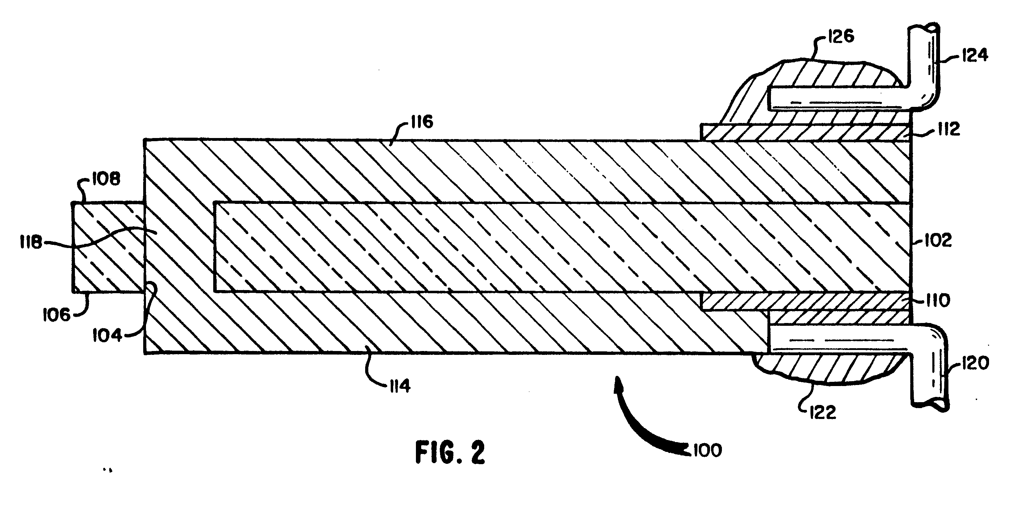

Figure 2 illustrates a cross-section of an electrical circuit component 100 according to this invention. An insulative substrate 102 is provided having an aperture 104 extending between first and second major surfaces 106 and 108 of the substrate. Metal Pad 110 is located on the first major surface of the substrate. Thick film PAC layers 114 and 116 are located on the first and second major surfaces of the substrate. The PAC layer 114 in part overlies the metal pad 110.. A portion 118 of the composition forming the PAC layers extends into the aperture 104 connecting the PAC layers on opposite surfaces of the substrate. A metal lead 120 is bonded to the first PAC layer and the metal land 110 by solder 122. A second metal lead 124 is connected to the second PAC layer through interposed metal pad 112 by solder 126. Instead of being soldered the leads can alternatively be bonded by any other convenient conventional means, such as ultrasonic wire bonding or thermal compression bonding.

Although for simplicity in Figure 2 the PAC layers are shown as forming linear conduction paths, they can independently form any conduction path configuration found in conventional circuits. For example, the conduction path can be serpentine or sinuous. It can be spiral, as in planar motor or generator windings. Further, instead of itself providing the entire conduction path between the leads 120 and 124, the PAC layers can form a conduction path in series and/or in parallel with conventional electrical circuit components, such as resistors, capacitors, transistors, diodes, integrated circuit elements, and the like.

Any heavy pnictide mixed alkaline earth copper oxide composition known to be convertible to a conductive crystalline phase can be employed in forming the coated articles of this invention. The term "heavy pnictide mixed alkaline earth copper oxide" refers to a composition of matter containing at least one heavy pnictide element, at least two alkaline earth elements, copper, and oxygen. The term "heavy pnictide" is employed to designate Group 15 elements having an atomic number of at least 51-i.e., bismuth and antimony, alone or in combination with a minor amount of lead. Generally the heavy pnictide is bismuth alone or in combination with from 0 to 30 mole percent of one or a combination of antimony and lead. The term "alkaline earth" indicates elements of Group 2. In a preferred form the mixed alkaline earth elements are a combination of calcium and at least one heavy alkaline earth-i.e., an alkaline earth having an atomic number of at least 38. The preferred heavy alkaline earth is strontium alone or in combination with from 0 to 10 mole percent barium, based on total heavy alkaline earth.

Superconductivity has been observed in crystalline phases of heavy pnictide mixed alkaline earth copper oxides which satisfy the metal ratios:

$P_2A_{x-y}Ca_yCu_z$

where

P is a heavy pnictide consisting essentially of bismuth and from 0 to 30 mole percent of one or a combination of antimony and lead,

A is heavy alkaline earth consisting essentially of strontium and from 0 to 10 mole percent barium,

x is the integer 3 or 4;

y ranges from 0.5 to 2; and

z is the integer 2 or 3.

In a preferred form in which the heavy pnictide is bismuth and the heavy alkaline earth is strontium, superconducting oxide phases satisfy the metal ratios:

$Bi_2Sr_{x-y}Ca_yCu_z$

where x, y, and z are as noted above. From studies of bulk bismuth strontium calcium copper oxides (BSCCO) the following crystalline phases and their superconducting characteristics have been correlated:

| BSCCO-2111 | 24Å | $8°K$ |
| BSCCO-2212 | 30Å | $80°K$ |
| BSCCO-2223 | 37Å | $105°K$ |

where the four digit number indicates the ratio of metal atoms in the crystal, the Angstrom indicates the identified crystal unit cell c axis length, and the temperature indicates $T_o$.

While strontium and calcium are indicated in these BSCCO compositions by whole numbers, the strontium and calcium are interchangeable in all proportions within the limits of y, suggesting that they form solid solutions. Thus, the BSCCO crystalline phases exhibiting superconductivity above the boiling point of liquid nitrogen ($77°K$) which are preferably present in the thick films of the conductive elements of the invention satisfy the relationships:

$Bi_2Sr_{3-y}Ca_yCu_2$

where y ranges from 0.5 to 1.5 and

$Bi_2Sr_{4-y}Ca_yCu_3$

where y ranges from 1.5 to 2.0.

To form these superconductive phases as a thick film the same metals in the same ratios are preferably employed in choosing the metal-ligand compounds employed as starting materials. However, it is not essential that the metals forming the metal-ligand compound starting materials be coated in the same proportions as they appear in the superconductive crystalline phase or phases of the final thick film. In crystallizing an excess of one or more of the metals is simply excluded from superconductive phase or phases being formed. The excluded metals remain as separate phases in the final thick film coating. As demonstrated in the Examples below large imbalances in metal ratios are entirely compatible with achieving superconductive thick films.

It is preferred that the metal-ligand compounds be selected to satisfy the relationship:

$P_aA_{b-c}Ca_cCu_d$

where

P is a heavy pnictide consisting essentially of bismuth and from 0 to 30 mole percent of one or a combination of antimony and lead,

A is heavy alkaline earth consisting essentially of strontium and from 0 to 10 mole percent barium,

a ranges from 2 to 5;

b ranges from 3 to 4;

c ranges from 0.5 to 2; and

d ranges from 2 to 5.

Where the heavy pnictide is barium and the heavy alkaline earth is strontium, the preferred ratios of metals in metal-ligand starting materials preferably satisfy the relationship:

$Bi_aSr_{b-c}Ca_cCu_d$

where

a ranges from 2 to 5;

b ranges from 3 to 4;

7

c ranges from 0.5 to 2; and

d ranges from 2 to 5.

BSCCO-2223 superconductive crystalline phases are particularly favored when the metal-ligand starting materials include an excess of either bismuth or copper.

The ligands present in the metal-ligand compounds described above form no part of the final article and therefore can be chosen based solely upon convenience in performing the process steps described above. Ligands are chosen first of all for their ability to form solutions in which heavy pnictide, alkaline earth, and copper combined with the ligands are each soluble in the desired proportions. Second, the ligands are chosen to be volatilizable during heating to form the intermediate PAC layer.

By "volatilizable" it is meant that the ligand or its component elements other than oxygen can be removed from the substrate surface at temperatures below the crystallization temperature of the PAC layer.

Inorganic ligands, such as nitrate, sulfate, and halide ligands, are illustrative of preferred ligands satisfying the criteria set forth above. Nitrate, bromide, and chloride ligands are particularly preferred. In general the ligands are chosen so that each of the heavy pnictide, alkaline earth, and copper ligand compounds exhibit approximately similar solubility characteristics.

Any evaporative solvent for the metal-ligand compounds can be employed for particle fabrication. Again, the solvent forms no part of the final article. Polar solvents, such as water or alcohols (e.g., methanol, ethanol, propanol, etc.), are particularly suited for use with metal-ligand compounds containing the inorganic ligands noted above.

Where a paste is coated, the paste contains either a small residual portion of the original solvent for the metal-ligand compounds or a different liquid to promote cohesion. The liquid fraction of the paste must be volatilizable. The evaporative solvents noted above all satisfy this criteria.

The paste apart from the metal-ligand particles can be identical in composition to conventional inks employed in screen printing. Screen printing inks normally contain an active ingredient (in this instance supplied by the metal-ligand particles), binders to promote substrate adhesion (such as glass frit or crystalline oxide powder), screening agents used to enhance the rheological properties of the ink-usually a higher molecular weight polymer, such as poly(vinyl alcohol) or poly(ethylene glycol), and a liquid, most commonly water or an alcohol. It is a particular advantage of this invention that the metal-ligand particles and liquid together provide excellent rheological and adhesion properties without the necessity of incorporating other screen printing ink ingredients.

Thick films produced by the present invention can vary widely in their thicknesses. Final thicknesses are contemplated in the range of from about 5 to 200 $\mu$m, with thicknesses of about 10 to 100 $\mu$m being preferred for most thick film applications. With care to avoid thermal stresses still greater coating thicknesses should be possible. Thin PAC films can be readily fabricated by the process of this invention.

The substrate of the thick film elements of this invention are referred to as insulative, only because it is insulative in comparison to the conduction properties of the PAC layer. As herein employed the term "insulative substrate" refers to any substrate having an electrical resistance of sufficiently greater magnitude than that of the PAC layer that current flow occurs predominantly through the PAC layer rather than the substrate on which it is formed. Where the circuit element is intended to be used at temperatures well below ambient, such as below $T_c$ or $T_o$ of the PAC layer, the insulative substrate can actually be more conductive than the PAC layer at ambient temperatures.

Electrically conductive crystalline PAC layers can be formed on a wide variety of substrates. In general any conventional electrical conductor substrate capable of withstanding processing temperatures can be employed. For example, metal, glass, ceramic, and semiconductor substrates all possess sufficient thermal stability to accept crystalline PAC layers applied by one or more of the procedures described above. Substrates in both polycrystalline and monocrystalline form have been successfully employed.

The present invention has provided for the first time PAC thick films exhibiting high $T_c$ and superconducting properties when coated on substrates comprised of an aluminum oxide or nitride. The thick film PAC layers of this invention can be formed on both monocrystalline and polycrystalline alumina. In addition, substrates which contain aluminum and oxygen in combination with one or more metals, such as in spinel substrates, are contemplated. $MgAl_2O_4$ is an exemplary substrate of this type. It is, of course, recognized that spinels in addition to those which contain aluminum as one metal elements can be employed as substrates useful in the practice of this invention.

Any of the various other types of substrates known to be useful in forming PAC thin or thick film conductive elements can also be employed. Alkaline earth oxides constitute a preferred class of substrate materials. They are in general relatively inert, refractory materials which exhibit limited interaction with the PAC layers during their formation. Magnesia in either monocrystalline (i.e., periclase) or polycrystalline form constitutes a particularly preferred substrate material because of its low level of interaction with the PAC layer. Strontium titanate, because it can be readily formed in a perovskite crystalline form, constitutes another preferred alkaline earth oxide substrate material.

Semiconductor wafers, particularly monocrystalline silicon and III-V compound wafers, also constitute useful classes of substrates for the articles of this invention.

Another specifically contemplated class of substrate materials are refractory metals. Such metals are, of course, well suited to withstanding PAC layer crystallization temperatures of 1000°C or more. Refractory metals such as tungsten, tantalum, titanium, and zirconium are particularly contemplated. The refractory metal can form the entire substrate or a thermally resistant layer onto which the PAC layer is coated.

Although some interaction between substrate materials and a contiguous PAC layer is believed to occur when the article is heated to temperatures above about 900°C, thick film PAC layers are much less affected by substrate interactions than thin PAC or RAC layers. Thus, direct coating of the PAC thick film onto a variety of substrate materials is contemplated.

Where barrier layers are contemplated to further reduce or eliminate interactions between the substrate and the PAC thick film, barriers can be chosen from a variety of materials. The refractory metals noted above, platinum (platinum, osmium, or iridium) metals, gold, and silver are all feasible barrier materials. The refractory metals under the conditions of processing convert to the corresponding oxides. When the substrate is silicon, a metal silicide barrier layer can be employed. Aluminum nitride and silicon nitride are both contemplated barrier layer materials. Generally any of the preferred substrate compositions noted above also form useful barrier layer compositions. The choice of a specific barrier layer or barrier layer combination will, of course, in many instances be influenced by the composition of the substrate and opportunities for simplifying processing that a particular substrate and barrier layer selection offers.

A specifically preferred, barrier layer triad arrangement particularly contemplated for silicon substrates is comprised of a first triad layer located adjacent the silicon substrate consisting essentially of silica, a third triad layer removed from the silicon substrate consisting essentially of at least one Group 4 heavy metal (i.e., zirconium or hafnium) oxide, a second triad layer interposed between the first and third triad layers consisting essentially of a mixture of silica and at least one Group 4 metal oxide. This barrier layer protects the silicon substrate from contamination by the overlying conductive layer, particularly against copper contamination and protects the conductive layer from silicon contamination.

The first step of the process for forming such a barrier layer triad is to form on the silicon substrate a silica layer of at least 2000 Å in thickness. The silica layer is preferably at least 5000 Å in thickness. Any convenient thickness of the silica layer can be formed beyond the minimum thickness required. Silica layer formation on silicon substrates can be achieved by any convenient conventional means and forms no part of this invention. The silica layer is in most instances conveniently formed by oxidation of the silicon substrate surface to form a grown silicon oxide layer. Alternatively, the silica layer can be deposited.

Following formation of the silica layer at least one Group 4 heavy metal is deposited on the silica layer. The term "Group 4 heavy metal" is herein employed to indicate the elements zirconium and hafnium, which occupy Group 4 of the periodic table of elements, as adopted by the American Chemical Society. Group 4 elements are also referred to as Group IVA elements using the IUPAC notation system for the periodic table of elements. The Group 4 heavy metal or metals are deposited to form a layer which is from about 1000 to 5000 Å in thickness. At lower layer thicknesses barrier effectiveness can be degraded by inadequate Group 4 heavy metal while at greater layer thicknesses physical stresses in the layer are increased, which can lead to physical defects. The Group 4 heavy metal layer can be deposited on the silica layer by any convenient conventional technique compatible with achieving the desired layer thicknesses. Techniques such as vacuum vapor deposition, chemical vapor deposition, metal organic vapor deposition, and sputtering are adequate to achieved the desired layer arrangement.

The next step is to convert the silica and Group 4 heavy metal layers into a barrier layer triad. The first step toward achieving this objective is to heat the two initially formed layers in the absence of a reactive atmosphere to a temperature at which oxygen migration can occur. Heating is best accomplished in a vacuum or in an inert gas atmosphere, such as an argon atmosphere. The objective is to drive oxygen out of the silica layer into the Group 4 heavy metal layer. This forms Group 4 heavy metal oxides in the Group 4 heavy metal layer at a location remote from the underlying silica layer. At the same time the Group 4 heavy metal reacts with the silica layer at its interface to form Group 4 heavy metal silicides.

The result is to form a barrier layer triad comprised of a first triad layer consisting essentially of silica, a third triad layer consisting essentially of at least one Group 4 heavy metal oxide, and a second triad layer of the barrier triad interposed between the first and second triad layers consisting essentially of at least one Group 4 heavy metal silicide.

The time and temperature of heating required to produce the necessary oxygen migration are interrelated. Oxygen migration can be achieved at lower temperatures and longer heating times or at higher

9

temperatures and shorter heating times. Generally temperatures of at least 700°C are required to produce significant oxygen migration, even when heating times are extended for 2 or more hours. On the other hand, it is not generally contemplated to employ heating temperatures in excess of about 1200°C. It is preferred to employ heating temperatures in the range of from about 750°C to 1000°C, with optimum heating temperatures being in the range of from about 800°C to 900°C. While adequate oxygen migration can occur by rapid thermal annealing at near maximum temperatures in time periods as low as about 1 minute, generally preferred heating times are from about 30 to 60 minutes.

Although the second triad layer as initially formed of Group 4 heavy metal silicide, this layer in the final conductive element may be totally or partially converted to a mixture of silica and Group 4 heavy metal oxide. This transformation results from subsequent heating in the presence of oxygen as may be employed in the formation of the conductive crystalline PAC layer to be formed over the barrier triad.

From the foregoing description it can be appreciated that the silicon substrate and the barrier layer triad together form the following sequence:

Third Triad Layer

Second Triad Layer

First Triad Layer

Silicon Substrate

In completed conductive elements of this invention the first triad layer has a thickness of at least about 1000 Å. The maximum thickness of this layer is not critical and can range above 1 μm, if desired. The second and third barrier triad layers also each preferably have thicknesses of at least about 1000 Å, but typically each have thicknesses of 5000 Å or less.

## Examples

The following examples illustrate the practice of the invention. The nitric acid referred to in the examples was in all instances fuming nitric acid. All steps were performed in air, except as specifically noted.

### Example 1

This example illustrates the formation of a conductive thick film crystallline coating of bismuth strontinum calcium copper oxide (BSCCO) on a polycrystalline alumina substrate.

### PFS-1

A particle-forming solution was prepared by mixing the following ingredients in the proportions indicated:

| | |
|---|---|
| $Bi(NO_3)_3 5H_2O$ | 48.51 g |
| $Sr(NO_3)_2$ | 21.16 g |
| $Ca(NO_3)_2 4H_2O$ | 8.21 g |
| $Cu(NO_3)_2 2.5H_2O$ | 23.27 g |
| $H_2O$ | 300.00 mL |
| $HNO_3$ | 20.00 mL. |

The water employed was distilled water. The bismuth was dissolved first in the water and nitric acid. The other nitrates were then added and a clear blue solution was obtained. The original intent was to prepare a composition containing bismuth, strontium, calcium, and copper in a 2212 atomic ratio, but chemical analysis by inductively coupled plasma (ICP) analysis revealed a 3313 ratio composition. A possible explanation is that the calcium nitrate contained more water than indicated. PFS-1 was diluted to 1 liter with water with 15 mL of nitric acid being added to avoid precipitation.

PFS-1 was converted to a powder by spray drying. A Yamato™ Model GA-31 spray drier was employed in its normal mode of operation.

Inlet Temp. 200° C
Outlet Temp. 90° C
Pump Setting 2.0
Drying Air 0.29-0.35 m³/min.
Atomizing Air 0.29 MPa
A #2050SS liquid nozzle and a #64-5SS air nozzle were used. The spray drier was preheated for 1 hour before spraying PFS-1, which was maintained at about 80° C during the run.

A paste was formed from the powder obtained by spraying by adding 19 Percent by weight water, based on the weight of the powder. The paste appeared to have good rheological properties for screen printing. The paste was coated on a 99.5% pure polycrystalline alumina substrate and heated at the rate of 3° C per minute under oxygen on a hot plate to a temperature of approximately 400° C.

The coated substrate was inserted into a furnace preheated to 875° C and held for 10 minutes. Upon examination of the structure of the thick film, there appeared to be two different types of regions. Long needle-like crystals were observed in a first type region, and a resistance of >100 ohms was observed in this type region. A dense mat of crystals appeared in a second type region, and a resistance of 20 to 60 ohms was observed in this type region.

Example 2

This example illustrates the formation of a BSCCO composition thick film on a polycrystalline magnesia substrate, with the film exhibiting a high superconducting onset transition temperature, $T_c$.

The paste from Example 1 was coated on a hot pressed polycrystalline magnesia substrate. The coated substrate was heated at the rate of 3° C/min to 500° C, held at that temperature for 5 minutes, ramped at the rate of 5° C per minute to 880° C, and held at 880° C for 10 minutes before cooling at the rate of less than 20° C per minute to room temperature.

The room temperature resistance of the BSCCO composition thick film on the polycrystalline magnesia substrate was >1 kilo-ohm. X-ray diffraction analysis indicated a randomly oriented 30Å (BSCCO 2212) crystalline phase.

The thick film coated substrate was then inserted into a furnace preheated to 880° C, fired for an additional 20 minutes at 880° C, and then quenched to room temperature. The sheet resistance of the thick film after this second heating was 3 to 4 ohms per square. X-ray diffraction analysis showed the randomly oriented 30Å crystalline phase to be predominant. Some secondary phases were also present, including a 24Å [BSCCO-2(11)1] phase.

The film showed a superconducting onset transition temperature, $T_c$, of 93° K. A resistance of less than about 0.5 ohm was observed at temperatures below 25° K.

Example 3

This example illustrates the formation of a superconducting crystalline BSCCO thick film on a monocrystalline magnesia substrate.

Aqueous stock solutions of 0.1 M bismuth nitrate, strontium nitrate. and copper nitrate were prepared. Additional nitric acid was added to the bismuth solution in order to dissolve the powder completely (7.5 mL/L $H_2O$). A 0.05 M calcium nitrate solution was also prepared. These solutions were mixed in equal parts to make the final nitrate solution employed for spray drying. The following parameters were used:
Inlet Temp. 200° C
Outlet Temp. 80° C
Pump Setting 2.0
Drying Air 0.32 m³/min.
Atomizing Air 0.2 MPa
A #2050SS liquid nozzle and a #64-5SS air nozzle were used. After approximately 1 hour spraying was interrupted, then recommenced with the atomizing air pressure increased to 0.25 MPa. The outlet temperature dropped to 60° C, but then returned to 80° C. The solution was sprayed at the rate of about 400 mL per hour. After changing to larger nozzles (#70SS air, #2850SS liquid), the outlet temperature dropped to 50° C, and the solution passed through the system without completely drying. To maintain the solubility of the salts, 20 mL of nitric acid was added to the solution accompanied by heating the solution to about 80° C. The final solute concentration of the solution was 0.03 g per mL, with a useable quantity of powder being formed.

A paste was made from the powder by adding less than 20 percent by weight water, based on the weight of the powder. The atomic ratio of bismuth, strontium, calcium, and copper in the paste was 2212. The paste is hereinafter referred to as the 2212 paste.

Samples of the 2212 paste and the 3313 paste prepared as described in Example 1 were coated on the {100} crystallographic surface of several substrates of monocrystalline magnesia. The coated substrates were heated at the rate of 3°C per minute to 500°C, held at 500°C for 5 minutes, ramped at 5°C per minute to 880°C, and held at that temperature before cooling at the rate of 10°C per minute to 850°C. The samples were held at 850°C for 10 minutes and then cooled to room temperature at the rate of 10°C per minute.

The substrate adhesion of the thick films prepared from both the 2212 and 3313 pastes was poor. The sheet resistance of samples A and B prepared from the 3313 paste were 17 and 8.3 ohms per square, respectively. The sheet resistance of samples K and L prepared from the 2212 paste were 47 and 20 ohms Per square, respectively.

The B and L samples were inserted into a furnace preheated to 890°C and held at that temperature for 10 minutes. The samples were cooled to room temperature at a rate of less than 20°C per minute.

The sheet resistance of sample B was 48 ohms per square. The sheet resistance of sample L was 2.3 ohms per square. The thickness of the sample L thick film was 15 $\mu$m.

Samples A and K, which did not receive the second firing, showed poorly crystallized X-ray diffraction patterns. Samples B and L, which received the second firing at 890°C, showed well crystallized, oriented films with 24Å and 30Å phases present. The second firing changed the thick film microstructure from small, randomly oriented grains to large oriented platelets interspersed with large needles. Sample L exhibited a superconducting onset transition temperature ($T_c$) of about 90°K and became superconducting at 76°K ($T_o$). Sample B exhibited a superconducting onset transition temperature ($T_c$) of about 90°K and became superconducting at 81°K ($T_o$).

When the differences in starting compositions and spraying conditions used in preparing the 3313 and 2212 pastes are taken into account, it is apparent that the process of the invention allows considerable lattitude in the composition of the solutions employed in spraying and the exact choice of spraying conditions. Interestingly, achieving the desired 30Å (BSCCO-2212) phase for low temperature conductivity does not depend on beginning with starting materials in this ratio. The examples additionally demonstrate the importance of reaching firing temperatures of at least 890°C in an oxidizing atomsphere, such as air, to achieve higher values of $T_c$ and $T_o$.

## Example 4

This example illustrates the preparation of a 30Å (BSCCO-2212) crystalline thick film on a polycrystalline alumina substrate.

The 2212 paste from Example 3 was coated on a 99.5% pure polycrystalline alumina substrate and heated at the rate of 3°C per minute to 500°C, held at 500°C for 5 minutes, ramped at the rate of 5°C per minute to 880°C, held at 880°C for 20 minutes, and then cooled at less than 20°C per minute to room temperature.

The thick film was well adhered to the substrate, but not uniform in its structure. In a first type region the thick film was made up predominantly of needle-like crystals. A second type region was made up predominantly of small grains as well as a few large platelets. X-ray diffraction analysis of the second type region showed predominatly randomly oriented 30Å phase with only a small amount of the 24Å phase. The sheet resistance of the second type of region was 24 ohms per square.

## Example 5

This example illustrates superconductivity at higher temperatures produced by interposing between initial heating and the maximum heating temperatures an intermediate heating sequence.

PFS-3

Additional nitric acid (20 mL/L $H_2O$) was mixed with PFS-2 (Example 3) to increase the solubility of bismuth nitrate.

The spray drying parameters used to convert the new solution into a powder were as follows:

Inlet Temp. 200°C

Outlet Temp. 80°C

Aspirator Setting 3

Pump Setting 2.0

Drying Air 0.23-0.27 m$^3$/min.

Atomizing Air 0.29 MPa

A #2850SS liquid nozzle and a #70SS air nozzle were used.

A 2212 paste was made from the powder by adding water. The paste was coated on the {100} crystallographic surface of several monocrystaline magnesia substrates. The coated substrates were heated at the rate of 3°C per minute to 500°C, held at 500°C for 5 minutes, ramped at the rate of 5°C per minute to 880°C, held at 880°C for 20 minutes, and then cooled at a rate of less than 20°C per minute to room temperature.

One sample (5A) was then inserted into a furnace, preheated to 885°C, and held at that temperature for 2.5 hours before quenching to room temperature. Examination of Sample 5A revealed a randomly oriented 30Å phase forming the thick film. Sample 5A was then heated to 900°C and held at this temperature for 12 minutes, followed by quenching to room temperature.

A second sample (5B) was heated to 900°C and held at that temperature for 12 minutes, followed by quenching to room temperature. The treatment of samples 5A and 5B therefore differed soley by the intermediate cycle of heating Sample 5A to 885°C.

The ratio of the X-ray diffraction analysis peak heights of the {008} crystallographic plane of the 30Å phase to that of the {006} crystallographic plane of the 24Å phase (23°2θ:22°2θ) was taken as an indication of the relative amounts of each phase. The ratio of the 30Å {0012} plane to the 24Å {0010} plane (37.2θ:35°2θ) was also examined. From comparisons based on the {008} and {006} planes, Sample 5A, which received the intermediate heating, showed a 45 percent increase in the 30Å phase as compared to Sample 5B. From comparisons based on the {0012} and {0010} planes, Sample 5A, which received the intermediate heating, showed a 53 percent increase in the 30Å phase as compared to Sample 5B.

The thickness of the thick film of Sample 5A decreased from 80 μm to 35 μm after 900°C heating step. The microstructures of both Samples 5A and 5B showed large, oriented platelets interspersed with large needles following the final heating step.

Sample 5A exhibited a $T_c$ of 86°K and a $T_o$ of 76°K. Sample 5B exhibited a $T_c$ of 89°K and a $T_o$ of 62°K. An improvement of 14°K in $T_o$ can therefore be attributed to the intermediate heating step.

## Example 6

This example illustrates superconductivity at higher temperatures resulting from following heating at 900°C with a post-firing to 875°C.

A sample was prepared similarly as in Example 5 through the step of heating to 880°C for 20 minutes and cooling to room temperature.

The sample was inserted into a furnace which had been preheated to 900°C and held there for 45 minutes before cooling. The sample was reinserted into the 900°C furnace and kept for an additional 2 hours to increase the proportion of the 24Å phase. The sample exhibited two types of regions. The first type of region was smooth and shiny with few needles. The second type of region had many needles and exhibited a brown tinge. X-ray diffraction analysis of both regions showed 24Å and 30Å phases to be present. Overall the X-ray diffraction patterns the regions were similar, except that the 30.2°2θ peak in first type region was more pronounced.

The sample was given a post heat treatment at 875°C for 1 hour. The 24Å phase completely disappeared from the X-ray diffraction pattern. The peak at 30.2°2θ was still present, however. The only change in the appearance of the microstructure was the emergence of small dark spots, observed using an optical microscope.

The thickness of the first type region was 90 μm, and its room temperature resistance was less than 1 ohm. The $T_c$ of this region was 97°K; the $T_o$ of this region was 85°K±2°K. This compared favorably with both Samples 5A and 5B.

## Example 7

This example illustrates the ability to achieve similar superconductivity results by firing in the presence of a non-oxidizing atmosphere, in this instance argon, but with firing temperatures being shifted to lower levels.

Samples were prepared similarly as in Example 5 through the step of heating to 880°C for 20 minutes and cooling to room temperature.

Sample 7A was inserted into a furance preheated to 835°C with flowing argon (100 cc/min at STP). The sample was held at 835°C in argon for 30 minutes and then quenched to room temperature in air.

Sample 7B was inserted into a furnace preheated to 835°C with flowing oxygen (100 cc/min at STP) for 30 minutes and then quenched to room temperature in air.

Sample 7A exhibited a thick film which was crystallographically oriented and well adhered to the substrate. Both 24Å and 30Å phases were present. The thickness of the film decreased from greater than 100 μm to 50 μm. The microstructure exhibited large oriented platelets interspersed with large needles.

Sample 7B exhibited a thick film which was poorly adhered to the substrate and randomly oriented. The microstructure was made up of fine grains. This demonstrated that higher temperatures are required for heating in an oxidizing atmosphere than in a non-oxidizing atmosphere.

Sample 7A was then heated to 790°C and held at 795 to 800°C for 30 minutes in argon to provide a post-firing heat treatment. X-ray diffraction analysis revealed only a 30Å phase. The microstructure revealed some additional small black spots when viewed with an optical microscope. The thickness of the film decreased to 23 μm.

One portion of Sample 7A (7A$^1$) was tested for superconductivity at this stage of processing while a second portion, 7A$^2$, was oxygen annealed for 3 hours at about 500°C. Sample 7A$^1$ had a $T_c$ of 87°K and a $T_o$ of 40°K. Sample 7A$^2$ had a $T_c$ of 88°K and a $T_o$ of 55°K.

Example 8

This example illustrates a superconducting crystalline BSCCO-2212 thick film on a polycrystalline alumina substrate.

A 2212 paste similar to that in Example 5 was coated on a 99.5% pure polycrystalline alumina substrate. The sample was heated at the rate of 5°C per minute to a temperature of 800°C and held at 800°C for 30 minutes, then cooled at a rate of less than 20°C per minute to room temperature. The sample was then inserted into a furnace preheated to 900°C and held for 7 minutes before quenching to room temperature. X-ray diffraction analysis showed randomly oriented 30Å phase crystallization and other second order phases.

The sample was then inserted into a furance preheated to 875°C and held for 10 minutes before quenching. The X-ray diffraction analysis was not significantly different.

The sample was again inserted into a furnace preheated to 900°C, held for 12 minutes, and then quenched to room temperature. The X-ray diffraction analysis showed a very well oriented 24Å phase and a small amount of the 30Å phase.

The sample was inserted into a furnace preheated to 880°C, held for 12 minutes, and then quenched to room temperature. The X-ray diffraction analysis showed a very well oriented 30Å phase and only a very small amount of the 24Å and other second order phases. $T_c$ was 87°K±1°K. $T_o$ was 62°K±1°K.

Claims

1. A process of forming an electrical conductor on a lower conductivity substrate comprising
forming a coating of a precursor of a crystalline heavy pnictide mixed alkaline earth copper oxide electrical conductor on the substrate and
converting the precursor to a crystalline heavy pnictide mixed alkaline earth copper oxide electrical conductor,
characterized by the steps of
spraying a solution comprised of a volatilizable solvent and a solute of metal-ligand compounds to form discrete liquid particles, the ligand moieties of the compounds being chosen to thermally decompose and the metal moieties of the compounds being chosen to provide the metals required for the precursor,
evaporating at least a portion of the volatilizable solvent from the liquid particles to form solid particles,
coating the solid particles on the substrate,
heating the coated particles in the presence of oxygen to form the precursor as an intermediate coating on the substrate, and

converting the intermediate coating to a crystalline heavy pnictide mixed alkaline earth copper oxide electrical conductor.

2. A process according to claim 1 further cahracterized in that the solid particles are formed by spray drying.

3. A process according to claim 2 further characterized in that

the liquid particles are generated in the form of a mist in a gaseous medium and

the solvent is evaporated from the liquid particles into the gaseous medium.

4. A process according to claim any one of claims 1 to 3 inclusive further characterized in that evaporation of the solvent is continued until the solid particles form a powder and the powder is then mixed with sufficient liquid to form a paste to facilitate coating.

5. A process according to any one of claims 1 to 3 inclusive further characterized in that evaporation of the solvent is discontinued after the solid particles are formed but before the solvent is entirely evaporated so that a paste is formed.

6. A Process according to any one of claims 1 to 5 inclusive further characterized in that the solvent is a polar solvent and the metal-ligand compounds are soluble inorganic salts of heavy pnictide, alkaline earth, and copper.

7. A process according to claim 6 further characterized in that the inorganic salts contain ligand moieties chosen from the class consisting of halide, nitrate, and sulfate anions.

8. A process according to claim 7 further characterized in that the halide ligand moieties are bromide or chloride anions.

9. A process according to claim 7 further characterized in that the ligand moieties are nitrate anions.

10. A process according to any one of claims 1 to 9 inclusive further characterized in that the intermediate coating is converted to a crystalline heavy pnictide mixed alkaline earth calcium copper oxide electrical conductor by heating to a temperature in the range of from 750 to 1000°C.

11. A process according to claim 10 further characterized in that the intermediate coating is heated in an oxygen containing atmosphere to a temperature in the range of from 850 to 950°C.

12. A process according to claim 11 further characterized in that the intermediate coating is heated in an oxygen containing atmosphere to a temperature in the range of from 890 to 950°C.

13. A process according to claim 12 further characterized in that prior to heating to 890 to 950°C the intermediate coating is heated in an oxygen containing atmosphere for a period of at least 5 minutes at a temperature in the range of from 800 to 885°C.

14. A process according to claim 12 further characterized in that following heating to 890 to 950°C the conductive coating produced is further heated in an oxygen containing atmosphere for at least 5 minutes in the temperature range of 870 to 890°C.

15. A process according to claim 10 further characterized in that the intermediate coating is heated in a non-oxidizing atmosphere to a temperature in the range of from 780 to 850°C.

16. A process according to claim 15 further characterized in that the intermediate coating is heated in a non-oxidizing atmosphere to a temperature in the range of from 830 to 850°C.

17. A process according to claim 16 further characterized in that following heating to 830 to 850°C the conductive coating produced is further heated in a non-oxidizing atmosphere for at least 5 minutes in the temperature range of 780 to 830°C.

18. A process according to claim 17 further characterized in that following heating to 780 to 830°C the conductive coating is heated in an oxygen containing atmosphere to a temperature of at least 480°C.

19. A process according to any one of claims 1 to 18 inclusive further characterized in that the heavy pnictide consists essentially of bismuth and from 0 to 30 mole percent of one or a combination of antimony and lead, based on total heavy pnictide, and the mixed alkaline earth consists essentially of heavy alkaline earth and calcium in a 3:1 to 1:3 molar ratio, where the heavy alkaline earth is strontium and from 0 to 30 mole percent barium, based on the total heavy alkaline earth.

FIG. 1

FIG. 2

EP 0 376 863 A2